# EUROPÄISCHE PATENTSCHRIFT

(11) **EP 2 859 368 B1**
(45) Veröffentlichungstag und Bekanntmachung des Hinweises auf die Patenterteilung: **31.07.2019**
(21) Anmeldenummer: 13725150.0
(22) Anmeldetag: 24.05.2013
(51) Int. Cl.: G01R 31/36

(54) **VERFAHREN ZUR BESTIMMUNG EINES OHMSCHEN INNENWIDERSTANDES EINES BATTERIEMODULS, BATTERIEMANAGEMENTSYSTEM UND KRAFTFAHRZEUG**
METHOD FOR DETERMINING THE INTERNAL OHMIC RESISTANCE OF A BATTERY MODULE, BATTERY MANAGEMENT SYSTEM AND MOTOR VEHICLE
PROCÉDÉ DE DÉTERMINATION D'UNE RÉSISTANCE INTERNE OHMIQUE D'UN MODULE DE BATTERIE, SYSTÈME DE GESTION DE BATTERIE ET VÉHICULE À MOTEUR

(30) Priorität: 08.06.2012 DE 102012209652
(43) Veröffentlichungstag der Anmeldung: 15.04.2015
(73) Patentinhaber: Robert Bosch GmbH, 70442 Stuttgart (DE); Samsung SDI Co., Ltd., Yongin-si, Gyeonggi-do 446-577 (KR)
(72) Erfinder: FINK, Holger, 70567 Stuttgart (DE)
(74) Vertreter: Bee, Joachim
(86) Internationale Anmeldenummer: PCT/EP2013/060742
(87) Internationale Veröffentlichungsnummer: WO 2013/182434

(56) Entgegenhaltungen:
- WO-A1-00/42690
- US-A1- 2010 250 163
- US-A1- 2011 298 626
- US-B1- 6 583 603

## Beschreibung

Die vorliegende Erfindung betrifft ein Verfahren zur Bestimmung eines ohmschen Innenwiderstandes eines Batteriemoduls mit mindestens einer Batteriezelle, beispielsweise eine Lithium-Ionen-Batteriezelle, wie sie etwa in Traktionsbatterien von Elektro- oder Hybridkraftfahrzeugen, also in Kraftfahrzeugen mit zumindest teil- oder zeitweise elektrisch betriebenen Antrieben, Verwendung findet. Die Erfindung betrifft daher auch ein Kraftfahrzeug und ein Batteriemanagementsystem.

### Stand der Technik

Durch verbesserte Speicherkapazität, häufigere Wiederaufladbarkeit und höhere Energiedichten finden Batterien immer breitere Anwendungen. Batterien mit geringerer Energiespeicherkapazität werden zum Beispiel für kleine tragbare elektronische Geräte wie Mobiltelefone, Laptops, Camcordern und dergleichen verwendet, während Batterien mit hoher Kapazität als Energiequelle für den Antrieb von Motoren von Hybrid- oder Elektro-Fahrzeugen, etc. oder als stationäre Batterien Verwendung finden.

Batterien können zum Beispiel durch das serielle Verschalten von Batteriemodulen gebildet werden, wobei teilweise auch parallele Verschaltungen der Batteriemodule erfolgen und die Batteriemodule ihrerseits aus seriell und/oder parallel verschalteten Batteriezellen bestehen können.

Für den Antrieb von Motoren von Hybrid- oder Elektro-Fahrzeugen sind insbesondere Mehrphasenbatteriesysteme geeignet, die auch als Batterie Direktinverter (BDI) bezeichnet werden. Mehrphasenbatteriesysteme umfassen mindestens zwei parallel geschaltete Batteriemodulstränge mit je einem oder mehreren seriell verschalteten Batteriemodulen. Die Batteriemodule weisen dabei eine Kopplungseinheit auf und sind mit deren Hilfe individuell zu- und abschaltbar, teilweise auch mit der Möglichkeit, zwischen einer positiven und einer negativen Zuschaltung zu wählen. Daher kann das Mehrphasenbatteriesystem durch entsprechendes Zu- und Abschalten der Module verwendet werden, mehrere zueinander phasenverschobene Wechselspannungen zu erzeugen. Bei entsprechender Auslegung können zum Beispiel drei zueinander phasenverschobene Wechselspannungsprofile erzeugt werden, die jeweils einer Sinuskurve angenähert und direkt zum Antrieb von Elektro- oder Hybridmotoren verwendbar sind.

Zum Batteriemanagement, zum Beispiel zur grundsätzlichen Ansteuerung von Modulen, zur Erhöhung der Sicherheit von Batterien, zur Effizienzsteigerung und zur Verlängerung der Lebenszeit von Batteriemodulen und aus Batteriemodulen zusammengesetzten Batteriesystemen werden Batteriemanagementsysteme eingesetzt. Eine Aufgabe von Batteriemanagementsystemen ist die Bestimmung des aktuellen Zustands der Batteriemodule. Zu den hierfür wichtigen Informationen zählt die Impedanz, der ohmsche Innenwiderstand des Batteriemoduls bzw. der im Batteriemodul enthaltenen Batteriezellen, wobei die Impedanz vom Ladungszustand, der Temperatur und dem Alterungsgrad der Batteriezellen abhängt.

Nach Stand der Technik erfolgen zugehörige Messungen meist außerhalb des Normalbetriebs der Batterie. Zum Beispiel wird in ISO 12405 vorgeschlagen, zu testende Batterien für Zeiträume im Sekundenbereich mit pulsförmigen Lade- und Entladeströmen zu belegen und die Spannung an der Batterie vor und nach dem Strompuls zu messen. Die Impedanz ergibt sich dann als Verhältnis der Differenz der gemessenen Spannungen zur Stärke des Strompulses.

Da die Strompulse für eine oder mehrere Sekunden anliegen, liegen auch die beiden Spannungsmessungen um diesen Zeitraum auseinander.

In der Druckschrift WO 00/42690 A1 wird weiterhin ein Verfahren zur Bestimmung eines ohmschen Innenwiderstandes eines Batteriemoduls offenbart, wobei das Verfahren die Bestimmung des ohmschen Innenwiderstandes aus Messungen von Spannungsstärken umfasst, wobei Messungen der Spannung vor und nach einer stufenförmigen Stromänderung verwendet werden.

In der Druckschrift US 2010/250163 A1 wird ein Verfahren zur Berechnung des Innenwiderstandes basierend auf einer Vielzahl an Strom-Spannungs-Wertepaaren und deren prozentualen Änderung offenbart.

### Offenbarung der Erfindung

Erfindungsgemäß wird ein Verfahren nach Anspruch 1 zum Bestimmen eines ohmschen Innenwiderstandes eines Batteriemoduls zur Verfügung gestellt. Dabei umfasst das Verfahren die Bestimmung des ohmschen Innenwiderstandes aus Messungen von Spannungsstärken. Die Erfindung ist dadurch gekennzeichnet, dass das Verfahren ein Zuschalten des Batteriemoduls zu mindestens einem weiteren unter einem Laststrom stehenden Batteriemodul umfasst, wobei das Verfahren die Messung von Spannungsstärken des Batteriemoduls vor und nach dem Zuschalten umfasst.

Dies ermöglicht eine deutlich zeitnähere und fast zeitgleiche Messung von Spannungsstärken, was wiederum eine bessere Bestimmung des tatsächlichen Abnutzungszustands des Batteriemoduls und Vorhersagen zur Haltbarkeit von einzelnen Batteriezellen oder von Batteriemodulen ermöglicht. Die Zuschaltung kann seriell oder parallel erfolgen.

Erfindungsgemäß wird weiterhin ein Batteriemanagementsystem für einen Batteriemodulstrang mit mindestens zwei seriell positiv und/oder negativ zu- und abschaltbaren Batteriemodulen gemäß Anspruch 5 vorgeschlagen. Der Batteriemodulstrang umfasst dabei eine Vorrichtung zur Messung von Batteriemodulspannungsstärken und eine Vorrichtung zur Übermittlung gemessener Spannungsstärken an das Batteriemanagementsystem. Das Batteriemanagementsystem ist ausgelegt, eine Änderung der übermittelten Batteriemodulspannungsstärken eines der mindestens zwei Batteriemodule infolge eines Zuschaltens des einen Batteriemoduls zu einem anderen der mindestens zwei Batteriemodule unter Laststrom zu bestimmen und zur Bestimmung einer Impedanz des einen Batteriemoduls zu verwenden.

Die Batteriemodule können in einem Ausführungsbeispiel Teil eines Batteriestrangs eines Mehrphasenbatteriesystems mit mindestens zwei parallelen Batteriesträngen sein, wobei das Mehrphasenbatteriesystem geeignet ist, mithilfe der mindestens zwei parallelen Batteriestränge zwei zueinander phasenverschobene Wechselspannungen zur Verfügung zu stellen.

In einer Ausführungsform des Verfahrens können daher die Messungen im Rahmen einer Zuschaltung des Batteriemoduls während der Erzeugung der Wechselspannung erfolgen.

In einer anderen Ausführungsform wird der bestimmte ohmsche Innenwiderstand mit einem vorgegebenen ohmschen Innenwiderstand zur Bestimmung einer Abweichung verglichen.

Dadurch kann ein Zustand übermäßiger Abnutzung des Batteriemoduls detektiert werden, der sich in einer Abweichung von einem Impedanzsollverhalten ausdrückt.

Sofern das Mehrphasenbatteriesystem geeignet ist, Wechselspannungen mit mindestens zwei verschiedenen Wechselspannungsprofilen zu erzeugen, kann das Verfahren in einer weiteren Ausführungsform das Bestimmen eines zeitlichen ohmschen Innenwiderstandprofils aus gemessenen Wechselspannungs- und gemessenen Stromprofilen und einen Vergleich des bestimmten ohmschen Innenwiderstandprofils mit einem durch eines der zwei Wechselspannungsprofile festgelegten ohmschen Innenwiderstandsprofil zur Bestimmung eines Abweichungsprofils umfassen. Das Abweichungsprofil wird dann als ein Indikator für einen Zustand übermäßiger Abnutzung des Batteriemoduls gewertet, wenn es in mindestens zwei Messpunkten einen Schwellwert übersteigt.

Dies ermöglicht eine kontinuierliche Überwachung des Mehrphasenbatteriesystems.

Erfindungsgemäß wird daher ein Mehrphasenbatteriesystem nach Anspruch 9 vorgestellt.

Das Mehrphasenbatteriesystem umfasst ein Batteriemanagementsystem im Sinne der Erfindung und mindestens zwei parallele Batteriemodulstränge, wobei das Mehrphasenbatteriesystem geeignet ist, mithilfe der mindestens zwei parallelen Batteriemodulstränge zueinander phasenverschobene Wechselspannungen und so eine vorbestimmte Wechselstromstärke zur Verfügung zu stellen.

Dieses Mehrphasenbatteriesystem eignet sich besonders zur Verwendung in einem Kraftfahrzeug.

Erfindungsgemäß wird daher weiterhin ein Kraftfahrzeug nach Anspruch 10 vorgestellt.

In einer Ausführungsform des Kraftfahrzeugs erfolgen Stromstärkenmessungen und Spannungsstärkenmessungen mit der notwendigen Häufigkeit und Präzision zur Bestimmung des Abnutzungszustandes der Batteriemodule im laufenden Betrieb des Mehrphasenbatteriesystems als Traktionsbatterie des Kraftfahrzeugs.

Vorteilhafte Weiterbildungen der Erfindung sind in den Unteransprüchen angegeben und in der Beschreibung beschrieben.

### Zeichnungen

Ausführungsbeispiele der Erfindung werden anhand der Zeichnungen und der nachfolgenden Beschreibung näher erläutert. Es zeigen:
Figur 1 ein beispielhaftes Batteriemodul, an dem die Erfindung Verwendung finden kann,
Figur 2 einen beispielhaften Batteriemodulstrang, an dem die Erfindung Verwendung finden kann,
Figur 3 ein beispielhaftes Mehrphasenbatteriesystem, an dem die Erfindung Verwendung finden kann, und
Figur 4 ein beispielhaftes Batteriemanagementsystem gemäß der Erfindung.

### Ausführungsformen der Erfindung

Die vorliegende Erfindung wurde im Rahmen der Entwicklung eines Mehrphasenbatteriesystems für ein Elektro- oder Hybridkraftfahrzeug gemacht und wird im Folgenden an diesem Ausführungsbeispiel beschrieben. Die Erfindung ist aber nicht auf dieses Ausführungsbeispiel beschränkt, sondern kann vorteilhaft in allen Batteriesystemen aus mehreren Batteriemodulen verwendet werden, die ein Zuschalten unter Last erlauben. Insbesondere ist der Verwendungszweck des Batteriesystems für die Erfindung nicht von Belang.

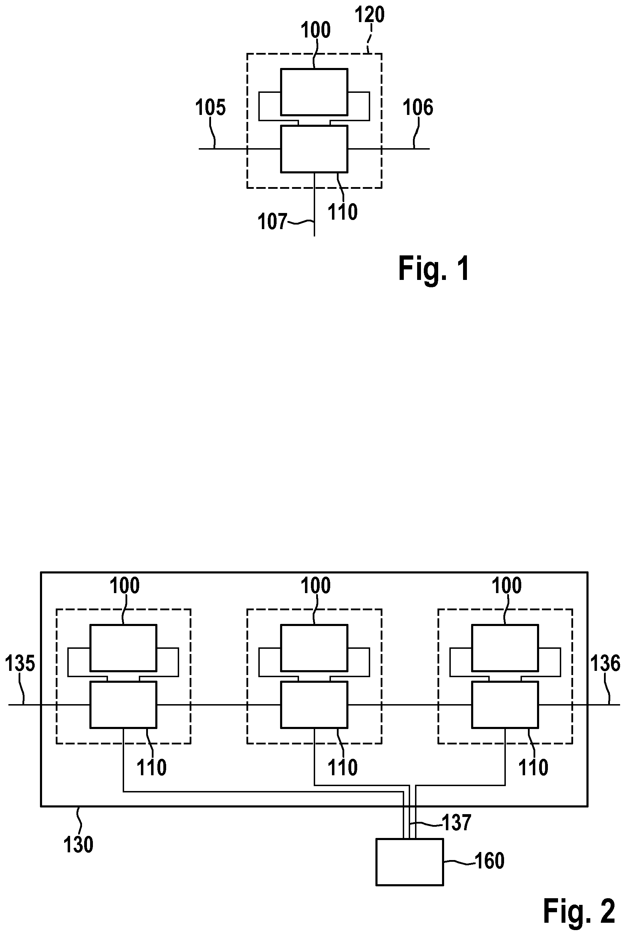

Figur 1 zeigt ein beispielhaftes Batteriemodul 100 mit einer Kopplungseinheit 110. Die Kopplungseinheit 110 ist entweder integraler Bestandteil des Batteriemoduls 100 oder, wie in Figur 1 gezeigt, Teil eines das Batteriemodul 100 umfassenden Systems 120. Die Kopplungseinheit 110 erlaubt es, das Batteriemodul 100 zumindest an- und abzuschalten, also zumindest von einem der Terminals 105 und 106 des Systems 120 zu trennen. Die Terminals 105 und 106 des Systems 120 werden auch als Batteriemodulpole bezeichnet. Die Kopplungseinheit 110 des dargestellten Beispiels ist hierfür über einen Signaleingang 107 ansteuerbar. Es ist aber auch möglich, dass die Kopplungseinheit 110 mit einer vorbestimmten Frequenz das Modul ohne externe Ansteuerung zu- und abschaltet. Dadurch kann eine Rechteckspannung erzeugt werden. Erlaubt die Kopplungseinheit 110 zudem die Festlegung der Polung beim Anschalten, so kann eine Rechteckwechselspannung erzeugt werden.

Werden nun mehrere solche Module 100 oder Systeme 120 seriell in einem Batteriemodulstrang 130 angeordnet, wie in Figur 2 gezeigt, und zeitversetzt wiederholend zu- und abgeschaltet, so kann ein annähernd sinusförmiger Spannungsverlauf einer Spannung zwischen den Terminals 135 und 136 des Batteriemodulstrangs 130 erzeugt werden. Die Terminals 135 und 136 des Batteriemodulstrangs 130 werden auch als Batteriestrangterminals oder Batteriestrangpole bezeichnet. Unter Last ergibt sich ein dem Spannungsverlauf entsprechender Stromverlauf.

In einem nicht gezeigten Ausführungsbeispiel werden alle in einem Strang zusammengefassten Module über eine einzige, gemeinsame Kopplungseinheit zu- und abgeschaltet. Diese kann ausgelegt sein, eine Wechselspannung mit vorbestimmter Frequenz zu erzeugen. Oder es kann eine Wechselspannung mit variabler Frequenz werden, sofern eine Ansteuerungsmöglichkeit der gemeinsamen Kopplungseinheit zur Variierung der Frequenz besteht.

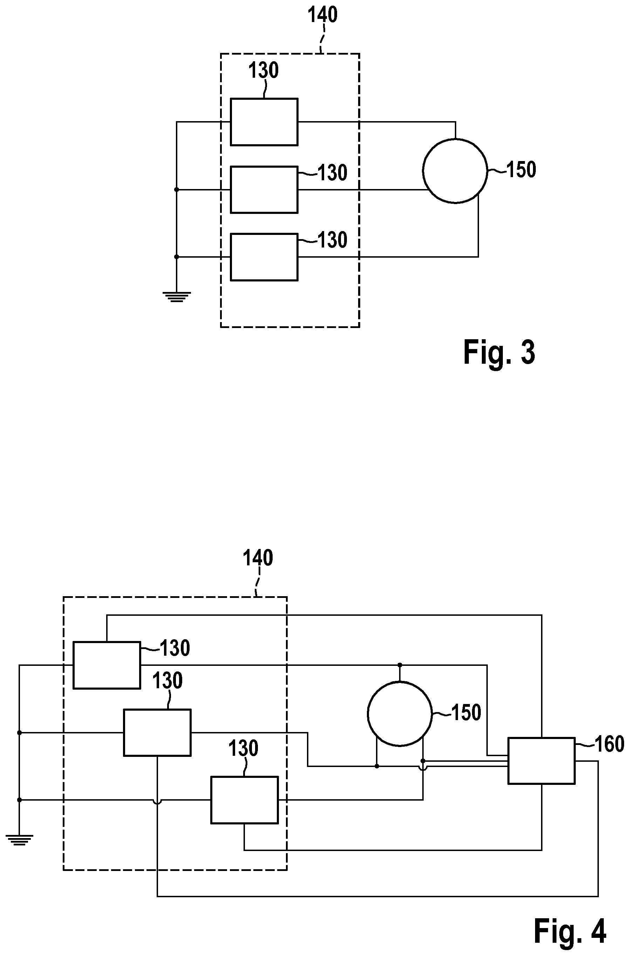

Figur 3 zeigt ein beispielhaftes Mehrphasenbatteriesystem 140, in dem drei Batteriemodulstränge 130 parallel zueinander angeordnet sind. Durch Ansteuerung der Kopplungseinheiten 110 werden in jedem der Stränge 130 die Module 100 so geschaltet, dass der jeweilige Strang 130 eine annähernd sinusförmige Wechselspannung bereitstellt. Dabei haben die Wechselspannungen der einzelnen Stränge 130 untereinander eine Phasenverschiebung, zum Beispiel von einer Drittelperiode. Das Mehrphasenbatteriesystem 140 ist daher geeignet ein rotierendes Feld zu erzeugen, mit dem ein Elektro- oder Hybridmotor 150 direkt angetrieben werden kann. Durch Veränderung der Amplituden der bereitgestellten Wechselspannungen und/oder der Phasenverschiebungen zueinander kann zudem der Stromverlauf in den Strängen und damit ein Drehmoment an eine vorgegebene Zielleistung des Motors 150 angepasst werden.

Unter Last erzeugt jeder dieser Zuschaltvorgänge dabei im zugeschalteten Batteriemodul 100 einen Stromstoß oder -puls, da der vor dem Zuschalten bereits durch den Strang 130 fließende Strom nun auch durch das neu zugeschaltete Modul 100 fließt.

Infolge dieses Stromstoßes oder -pulses verändert sich die Modulspannung von in dem Modul 100 zusammengefassten Batteriezellen und damit auch die Spannung des Moduls 100. Der Zeitrahmen, innerhalb dem diese Änderung erfolgt, ist dabei maßgeblich durch die Zuschaltung bestimmt und liegt deutlich unter einer Sekunde. Es wird daher eine genaue Messung einer augenblicklichen Spannungsänderung möglich.

Mithilfe der Messung der Spannungsänderung am Modul 100 infolge des Zuschaltens und der Stromstärke des zum Schaltzeitpunkt durch das Modul fließenden Stroms kann daher die Impedanz des zugeschalteten Moduls aus dem Verhältnis Spannungsänderung zu Stromstärke bestimmt werden.

Diese Bestimmung ist also im laufenden Betrieb, unter Last, und mit einer Häufigkeit möglich, die einer Häufigkeit von Zuschaltvorgängen entspricht. Sofern sich die gemessene Impedanz im Betrieb ändert, ohne dass sich die vorgegebene Zielleistung des Motors 150 geändert hätte, so ist dies ein Hinweis auf einen Alterungsprozess des betreffenden Moduls. Weiterhin ist es möglich, zu verschiedenen vorgebbaren Zielleistungen des Motors 150 entsprechende Sollimpedanzen in einer Speichereinheit eines Batteriemanagementsystems zu hinterlegen. Dann kann eine Abweichung einer bei einer gegebenen Zielleistung aus Messungen bestimmten Impedanz von der zu der gegebenen Zielleistung in der Speichereinheit hinterlegten Sollimpedanz ein Hinweis für eine Veränderung von Batteriezellen in dem Modul sein.

Weiterhin kann, wenn Zuschaltungen von Modulen 100 zum zugehörigen Strang 130 unter verschiedenen Phasenlagen des Stroms, also bei unterschiedlichen Stromstärken, erfolgen, für eines, mehrere oder alle Module des Strangs 130 jeweils ein Impedanzprofil bestimmt werden. Sofern sich ein solches Impedanzprofil im Betrieb ändert, ohne dass sich die vorgegebene Zielleistung des Motors 150 geändert hätte, so ist dies ein Hinweis auf einen Alterungsprozess des betreffenden Moduls. Weiterhin ist es möglich, entsprechende Sollimpedanzprofile in der Speichereinheit zu hinterlegen. Wieder kann eine Abweichung des gemessenen Impedanzprofils vom Sollimpedanzprofil ein Hinweis für Modulalterung sein.

In einem nicht gezeigten Ausführungsbeispiel werden alle in einem Mehrphasenbatteriesystem zusammengefassten Module über eine einzige, gemeinsame Kopplungseinheit zu- und abgeschaltet.

Figur 4 zeigt ein beispielhaftes Batteriemanagementsystem 160 im Zusammenspiel mit dem in Figur 3 gezeigten beispielhaften Mehrphasenbatteriesystem 140. Das Batteriemanagementsystem 160 erfasst die von den Batteriemodulsträngen 130 dem Motor 150 zur Verfügung gestellten Wechselspannungen und die fließenden Ströme und steuert über Verbindungen zu den Strängen 130 die in den Strängen 130 angeordneten Module 100 oder Systeme 120.

Die Erfindung erlaubt also eine quasi-kontinuierliche Überwachung der Modulzustände im laufenden Betrieb. Dies ermöglicht, Effizienzeinbußen oder gar Defekte von Modulen schnell und sicher zu erkennen. Dies ist vorteilhaft, weil die als defekt oder alternd erkannten Module ausgetauscht werden können und weil Störungen der durch den Batteriestrang bereitgestellten Leistung durch das defekte oder alternde Modul durch entsprechende Änderung der Ansteuerungen der Kopplungseinheiten zumindest teilweise kompensiert werden können.

## Patentansprüche

1. Verfahren zur Bestimmung eines ohmschen Innenwiderstandes eines Batteriemoduls (100), wobei das Verfahren die Bestimmung des ohmschen Innenwiderstandes aus Messungen von Spannungsstärken umfasst,
**dadurch gekennzeichnet, dass**
das Verfahren ein Zuschalten des Batteriemoduls (100) zu mindestens einem weiteren unter einem Laststrom stehenden Batteriemodul (100) umfasst, wobei das Verfahren die Messung von Spannungsstärken des Batteriemoduls (100) vor und nach dem Zuschalten umfasst.

2. Verfahren nach Anspruch 1, wobei das Verfahren einen Vergleich des bestimmten ohmschen Innenwiderstandes mit einem vorgegebenen ohmschen Innenwiderstand zur Bestimmung einer Abweichung umfasst.

3. Verfahren nach Anspruch 1 oder 2, wobei das Batteriemodul (100) und das mindestens eine weitere Batteriemodul (100) seriell positiv oder negativ zugeschaltet oder abgeschaltet werden können und einen Batteriemodulstrang (130) bilden, der geeignet ist, durch Schalten der Batteriemodule (100) eine Wechselspannung zu erzeugen und wobei die Messungen im Rahmen einer Zuschaltung des Batteriemoduls (100) während der Erzeugung der Wechselspannung erfolgen.

4. Verfahren nach Anspruch 3, wobei der Batteriemodulstrang Teil eines Batteriesystems (140) mit mehreren Batteriemodulsträngen (130) ist und das Batteriesystem (140) geeignet ist, Wechselspannungen mit mindestens zwei verschiedenen Wechselspannungsprofilen zu erzeugen, und wobei das Verfahren das Bestimmen eines zeitlichen ohmschen Innenwiderstandprofils und einen Vergleich des bestimmten ohmschen Innenwiderstandprofils mit einem durch eines der zwei Wechselspannungsprofile festgelegten ohmschen Innenwiderstandsprofil zur Bestimmung eines Abweichungsprofils umfasst, wobei das Abweichungsprofil als ein Indikator für einen Zustand übermäßiger Abnutzung des Batteriemoduls (100) gewertet wird, wenn es in mindestens zwei Messpunkten einen Schwellwert übersteigt.

5. Batteriemanagementsystem (160) für einen Batteriemodulstrang (130) mit mindestens zwei seriell positiv und/oder negativ zu- und abschaltbaren Batteriemodulen (100), wobei der Batteriemodulstrang (130) eine Vorrichtung zur Messung von Batteriemodulspannungsstärken umfasst und weiterhin eine Vorrichtung zur Übermittlung gemessener Modulspannungsstärken an das Batteriemanagementsystem (160) umfasst,
**dadurch gekennzeichnet, dass**
das Batteriemanagementsystem (160) ausgelegt ist, eine Änderung der übermittelten Batteriemodulspannungsstärken eines der mindestens zwei Batteriemodule (100) infolge eines Zuschaltens des einen der mindestens zwei Batteriemodule (100) zu mindestens einem unter einem Laststrom stehenden anderen der mindestens zwei Batteriemodule (100) zu bestimmen und zur Bestimmung einer Impedanz des einen der mindestens zwei Batteriemodule (100) zu verwenden.

6. Batteriemanagementsystem (160) nach Anspruch 5 wobei das Batteriemanagementsystem (160) weiterhin ausgelegt ist, eine bestimmte Modulspannungsstärkenänderung mit einer vorgegebenen Modulspannungsstärkenänderung zur Bestimmung einer Abweichung und die bestimmte Abweichung mit einem Schwellwert zu vergleichen.

7. Batteriemanagementsystem (160) nach Anspruch 5 oder 6, wobei der Batteriemodulstrang (130) geeignet ist, durch Schalten der Batteriemodule (100) eine Wechselspannung zu erzeugen und wobei das Batteriemanagementsystem (160) ausgelegt ist, eine Modulspannungsstärkenänderung infolge einer Zuschaltung des Batteriemoduls (100) während der Erzeugung der Wechselspannung zu bestimmen.

8. Batteriemanagementsystem (160) nach Anspruch 7, wobei der Batteriemodulstrang (130) geeignet ist, Wechselspannungen mit mindestens zwei verschiedenen Wechselspannungsstärkenprofilen zu erzeugen, und wobei das Batteriemanagementsystem (160) ausgelegt ist, ein zeitliches Impedanzprofil zu bestimmen und mit einem durch eines der zwei Wechselspannungsstärkenprofile bestimmten Sollimpedanzprofil zur Bestimmung eines Abweichungsprofils zu vergleichen, wobei das Abweichungsprofil als ein Indikator für einen Zustand übermäßiger Abnutzung des Batteriemoduls (100) gewertet wird, wenn es in mindestens zwei Messpunkten einen Schwellwert übersteigt.

9. Mehrphasenbatteriesystem (140) umfassend ein Batteriemanagementsystem (160) nach einem der Ansprüche 5 bis 8 und mindestens zwei parallele Batteriemodulstränge (130), wobei das Mehrphasenbatteriesystem (140) geeignet ist, mithilfe der mindestens zwei parallelen Batteriemodulstränge (130) zueinander phasenverschobene Wechselspannungen und so eine vorbestimmte Wechselstromstärke zur Verfügung zu stellen.

10. Kraftfahrzeug mit einer zumindest zeit- oder teilweise elektrisch betreibbaren Antriebseinheit (150), mit einem Batteriemanagementsystem (160) nach einem der Ansprüche 5 bis 8 und mindestens zwei von einem Mehrphasenbatteriesystem (140) umfassten parallelen Batteriemodulsträngen (130), wobei das Mehrphasenbatteriesystem (140) geeignet ist, mithilfe der mindestens zwei parallelen Batteriemodulstränge (130) zueinander phasenverschobene Wechselspannungen und so eine vorbestimmte Wechselstromstärke der Antriebseinheit (150) zur Verfügung zu stellen.

## Claims

1. Method for determining the internal ohmic resistance of a battery module (100), wherein the method comprises the determination of the internal ohmic resistance from measurements of voltage intensities,
**characterized in that**
the method comprises the connection of the battery module (100) to at least one further battery module (100) that is subject to a load current, wherein the method comprises the measurement of voltage intensities of the battery module (100) before and after the connection.

2. Method according to Claim 1, wherein the method comprises a comparison of the determined internal ohmic resistance with a predefined internal ohmic resistance in order to determine a deviation.

3. Method according to Claim 1 or 2, wherein the battery module (100) and the at least one further battery module (100) can be connected or disconnected in series positively or negatively and can form a battery module bank (130) that is suitable, by connecting the battery modules (100), for generating an alternating voltage, and wherein the measurements are taken within the scope of a connection of the battery module (100) during the generation of the alternating voltage.

4. Method according to Claim 3, wherein the battery module bank is part of a battery system (140) comprising a number of battery module banks (130) and the battery system (140) is suitable for generating alternating voltages having at least two different alternating voltage profiles, and wherein the method comprises the determination of an internal ohmic resistance profile over time and a comparison of the determined internal ohmic resistance profile with an internal ohmic resistance profile fixed by one of the two alternating voltage profiles in order to determine a deviation profile, wherein the deviation profile is deemed to be an indicator for a state of excessive wear of the battery module (100) if it exceeds a threshold value in at least two measurement points.

5. Battery management system (160) for a battery module bank (130) comprising at least two battery modules (100) connectable and disconnectable in series positively and/or negatively, wherein the battery module bank (130) comprises a device for measuring battery module voltage intensities and furthermore a device for transmitting measured module voltage intensities to the battery management system (160),
**characterized in that**
the battery management system (160) is designed to determine a change of the transmitted battery module voltage intensities of one of the at least two battery modules (100) as a result of a connection of the first-mentioned of the at least two battery modules (100) to at least one other of the at least two battery modules (100) under load current, and to use this change to determine an impedance of the first-mentioned of the at least two battery modules (100).

6. Battery management system (160) according to Claim 5, wherein the battery management system (160) is also designed to compare a determined module voltage intensity change with a predefined module voltage intensity change in order to determine a deviation and to compare the determined deviation with a threshold value.

7. Battery management system (160) according to Claim 5 or 6, wherein the battery module bank (130) is suitable for generating an alternating voltage by connecting the battery modules (100), and wherein the battery management system (160) is designed to determine a module voltage intensity change as a result of a connection of the battery module (100) during the generation of the alternating voltage.

8. Battery management system (160) according to Claim 7, wherein the battery module bank (130) is suitable for generating alternating voltages having at least two different alternating voltage intensity profiles, and wherein the battery management system (160) is designed to determine an impedance profile over time and to compare this with a target impedance profile determined by one of the two alternating voltage intensity profiles in order to determine a deviation profile, wherein the deviation profile is deemed to be an indicator for a state of excessive wear of the battery module (100) if it exceeds a threshold value in at least two measurement points.

9. Multi-phase battery system (140) comprising a battery management system (160) according to one of Claims 5 to 8 and at least two parallel battery module banks (130), wherein the multi-phase battery system (140) is suitable for providing alternating voltages phase-shifted in relation to one another and thus a predetermined alternating current intensity with the aid of the at least two parallel battery module banks (130).

10. Motor vehicle comprising a drive unit (150) that can be electrically operated at least intermittently or partly, comprising a battery management system (160) according to one of Claims 5 to 8 and at least two parallel battery module banks (130) comprised by a multi-phase battery system (140), wherein the multi-phase battery system (140) is suitable for providing alternating voltages phase-shifted in relation to one another and thus a predetermined alternating current intensity of the drive unit (150) with the aid of the at least two parallel battery module banks (130) .

## Revendications

1. Procédé de détermination d'une résistance interne ohmique d'un module de batterie (100), le procédé comprenant la détermination de la résistance interne ohmique à partir de mesures des amplitudes de tension,
**caractérisé en ce que**
le procédé comprend une mise en circuit du module de batterie (100) vers au moins un module de batterie (100) supplémentaire qui se trouve sous un courant de charge, le procédé comprenant la mesure des amplitudes de tension du module de batterie (100) avant et après la mise en circuit.

2. Procédé selon la revendication 1, le procédé comprenant une comparaison de la résistance interne ohmique déterminée avec une résistance interne ohmique prédéfinie en vue de déterminer un écart.

3. Procédé selon la revendication 1 ou 2, le module de batterie (100) et l'au moins un module de batterie (100) supplémentaire pouvant être mis en circuit ou hors circuit en série positivement ou négativement et formant une branche de modules de batterie (130) qui est adaptée, par commutation des modules de batterie (100), pour générer une tension alternative et les mesures étant effectuées dans le cadre d'une mise en circuit du module de batterie (100) pendant la génération de la tension alternative.

4. Procédé selon la revendication 3, la branche de modules de batterie faisant partie d'un système de batterie (140) comprenant plusieurs branches de modules de batterie (130) et le système de batterie (140) étant adapté pour générer des tensions alternatives avec au moins deux profils de tension alternative différents, et le procédé comprenant la détermination d'un profil de résistance interne ohmique temporel et une comparaison du profil de résistance interne ohmique déterminé avec un profil de résistance interne ohmique constaté avec l'un des deux profils de tension alternative en vue de déterminer un profil d'écart, le profil d'écart étant évalué en tant qu'indicateur pour un état de dégradation excessive du module de batterie (100) s'il dépasse une valeur de seuil en au moins deux points de mesure.

5. Système de gestion de batterie (160) pour une branche de modules de batterie (130) comprenant au moins deux modules de batterie (100) pouvant être mis en circuit ou hors circuit en série positivement et /ou négativement, la branche de modules de batterie (130) comprenant un dispositif de mesure des amplitudes de tension de module de batterie et en outre un dispositif destiné à communiquer les amplitudes de tension de module mesurées au système de gestion de batterie (160),
**caractérisé en ce que**
le système de gestion de batterie (160) est conçu pour déterminer une variation des amplitudes de tension de module de batterie communiquées de l'un des au moins deux modules de batterie (100) du fait d'une mise en circuit dudit un des au moins deux modules de batterie (100) vers au moins un autre des au moins deux modules de batterie (100) qui se trouve sous un courant de charge et pour l'utiliser en vue de déterminer une impédance de l'un des au moins deux modules de batterie (100) .

6. Système de gestion de batterie (160) selon la revendication 5, le système de gestion de batterie (160) étant en outre conçu pour comparer une variation donnée des amplitudes de tension de module avec une variation prédéfinie des amplitudes de tension de module en vue de déterminer un écart et comparer l'écart déterminé avec une valeur de seuil.

7. Système de gestion de batterie (160) selon la revendication 5 ou 6, la branche de modules de batterie (130) étant adaptée, par commutation des modules de batterie (100), pour générer une tension alternative et le système de gestion de batterie (160) étant conçu pour déterminer une variation des amplitudes de tension de module résultant d'une mise en circuit du module de batterie (100) pendant la génération de la tension alternative.

8. Système de gestion de batterie (160) selon la revendication 7, la branche de modules de batterie (130) étant adaptée pour générer des tensions alternatives ayant au moins deux profils d'amplitude de tension alternative différents et le système de gestion de batterie (160) étant conçu pour déterminer un profil d'impédance temporel et le comparer avec un profil d'impédance de consigne déterminé avec l'un des deux profils d'amplitude de tension alternative en vue de déterminer un profil d'écart, le profil d'écart étant évalué en tant qu'indicateur pour un état de dégradation excessive du module de batterie (100) s'il dépasse une valeur de seuil en au moins deux points de mesure.

9. Système de batterie multiphasé (140) comprenant un système de gestion de batterie (160) selon l'une des revendications 5 à 8 et au moins deux branches de modules de batterie (130) en parallèle, le système de batterie multiphasé (140) étant adapté pour mettre à disposition, à l'aide des au moins deux branches de modules de batterie (130) en parallèle, des tensions alternatives mutuellement déphasées et ainsi une intensité de courant alternatif prédéterminée.

10. Véhicule automobile comprenant une unité de propulsion (150) pouvant fonctionner au moins temporairement ou partiellement de manière électrique, comprenant un système de gestion de batterie (160) selon l'une des revendications 5 à 8 et au moins deux branches de modules de batterie (130) en parallèle comprise par un système de batterie multiphasé (140), le système de batterie multiphasé (140) étant adapté pour mettre à disposition de l'unité de propulsion (150), à l'aide des au moins deux branches de modules de batterie (130) en parallèle, des tensions alternatives mutuellement déphasées et ainsi une intensité de courant alternatif prédéterminée.
